# DEMANDE DE BREVET EUROPEEN

(11) **EP 2 175 400 A1**
(43) Date de publication de la demande: **14.04.2010**
(21) Numéro de dépôt: 08166095.3
(22) Date de dépôt: 08.10.2008
(51) Int. Cl.: G06K 19/077

(54) **Procédé de fabrication d'un dispositif de communication RF formé d'un fil d'antenne relié à une unité électronique**

(71) Demandeur: NagralD, 2301 La Chaux-de-Fonds (CH)
(72) Inventeur: Droz, François, 2035 Corcelles (CH)
(74) Mandataire: Surmely, Gérard

(57) **Abrégé**

L'invention concerne un procédé de fabrication d'un dispositif de communication RF (12) qui comprend une antenne (2) formée par un fil électrique et au moins une unité électronique (10) reliée électriquement à cette antenne. Le procédé se caractérise par le fait que des zones respectives (8, 9) d'extrémités du fil électrique sont aplaties par écrasement dans une étape préliminaire à l'assemblage de l'antenne avec l'unité électronique. Cet assemblage, notamment par soudage, est réalisé de manière que des plages ou plots de connexion de l'unité électronique sont reliées respectivement aux zones aplaties dudit fil de l'antenne. De préférence, les zones aplaties recouvrent entièrement les plages ou plots respectifs du circuit électronique.

## Description

### Domaine de l'invention

La présente invention concerne un procédé de fabrication d'un dispositif de communication RF comprenant une antenne formée d'un fil électrique et d'une unité électronique auquel le fil d'antenne est relié électriquement. En particulier, l'invention concerne un tel dispositif de communication incorporé notamment dans une carte, une étiquette ou un jeton électronique.

De tels dispositifs peuvent être des transpondeurs passifs ou actifs utilisés dans de nombreuses applications, par exemple dans le domaine bancaire, pour des titres de transport ou en général pour l'identification de personnes, d'animaux ou d'objets.

### Arrière plan technologique

Un aspect important dans la fabrication de dispositifs de communication RF est la liaison électrique ou l'assemblage du fil électrique formant l'antenne à l'unité électronique. L'unité électronique considérée principalement dans le cadre de la présente invention est soit un circuit intégré présentant des plots ou plages de connexion électrique, soit un circuit intégré agencé dans un boîtier ou dans un enrobage qui présente à une surface externe des plots ou plages de connexion électrique.

On connaît du document US 5,572,410 un procédé de fabrication d'un transpondeur dans lequel la bobine-antenne est formée par un fil électrique isolé qui est enroulé dans un dispositif de bobinage. Par des moyens de guidage appropriés, ce fil est tendu au-dessus d'un premier plot d'un circuit électronique, puis l'enroulement est effectué et finalement le fil est ramené vers le circuit électronique et tendu au-dessus d'un deuxième plot dudit circuit électronique. Ainsi, avant de couper le fil pour obtenir une bobine libre, les deux extrémités de cette bobine sont agencées parallèlement au-dessus de deux plots d'un circuit électronique. A l'aide d'une thermode, on effectue alors une thermo-compression des deux extrémités de la bobine sur les deux plots respectifs du circuit électronique pour relier l'antenne à ce circuit.

Comme le suggère les figures de ce document US 5,572,410 et comme le confirme le document US 5,281,855, le soudage du fil électrique est effectué sur des plots de grandes dimensions, c'est-à-dire de dimensions agrandies relativement à des plots de dimensions standard. On parle alors de « Megabumps » ou de « Megapads » (selon la terminologie anglaise utilisés dans ce domaine technique). Dans la pratique, de tels plots de connexion présentent une surface supérieure sensiblement plane avec une largeur supérieure au diamètre du fil électrique de sorte que, dans les tolérances de positionnement qu'il est possible d'assurer, les deux extrémités de la bobine sont situées entièrement dans la largeur des plots respectifs. On prévoit ainsi que le fil électrique soit entièrement en regard d'une surface sensiblement plane ayant une largeur suffisante pour assurer que ce fil électrique reste sur chaque plot lors du soudage notamment par thermo compression et ne roule pas ou ne glisse pas à côté d'un des deux plots. Une telle technique d'assemblage nécessite donc la fabrication de circuit intégré spécifique avec des plots de grandes dimensions. Ceci augmente le coût de fabrication de tels circuits intégrés et, dans certains cas, également leurs dimensions. De plus, pour de très petits circuits intégrés, une telle technologie devient économiquement non viable puisqu'il est nécessaire d'augmenter considérablement les dimensions du circuit intégré pour pouvoir agencer des plots de grandes dimensions tels que décrit ci-avant. Dans le domaine de la fabrication de cartes électroniques, certains fabricants ont opté pour une solution où le circuit intégré est incorporé dans un module ayant deux languettes externes qui sortent d'un enrobage de ce circuit.

Le but de la présente invention est de proposer un procédé de fabrication de dispositifs de communication RF qui permettent d'assembler aisément et sûrement une antenne formée d'un fil électrique à un circuit électronique ayant des plots ou plages de connexion de dimensions standard, et ceci également avec des circuits intégrés de très petites dimensions présentant des plots de petites dimensions relativement au diamètre du fil électrique formant la bobine-antenne.

### Résumé de l'invention

A cet effet, la présente invention concerne un procédé de fabrication d'un dispositif de communication RF comprenant une antenne formée par un fil électrique et au moins une unité électronique comprenant des plots ou plages de connexion à ladite antenne qui sont reliés électriquement à des zones respectives de cette antenne, **caractérisé en ce que** ces zones respectives sont aplaties par écrasement dans une étape préliminaire à l'assemblage de l'antenne avec ladite unité électronique, cet assemblage étant réalisé en positionnant lesdits plots ou plages de connexion en face respectivement des zones aplaties dudit fil de l'antenne.

Grâce aux caractéristiques du procédé de fabrication selon l'invention, les zones aplaties du fil électrique, auxquelles les plots ou plages de l'unité électronique sont reliés électriquement, présentent premièrement une largeur supérieure au diamètre de ce fil électrique et deuxièmement une surface inférieure sensiblement plane. De ce fait, les plots ou plages ne doivent plus nécessairement présenter une surface supérieure sensiblement plane et de plus les plots peuvent présenter des dimensions inférieures à celles desdites zones aplaties. Dans le cadre de la présente invention, ce n'est plus le plot qui doit présenter une largeur supérieure au diamètre du fil et une surface sensiblement plane permettant d'écraser le fil sur le plot sans que celui-ci ne roule ou ne glisse à côté du plot, mais c'est le fil électrique aplati localement dans une étape préliminaire qui présente de préférence une largeur supérieure à la largeur d'un plot de connexion et qui définit une surface sensiblement plane assurant un maintien en position des extrémités de l'antenne lors de l'assemblage de cette antenne à ladite unité électronique, notamment par soudage.

En prenant les mesures nécessaires pour que les zones aplaties ne se touchent pas lors du soudage aux plots respectifs de l'unité électronique, il est possible d'assembler aisément et de manière sûre une antenne formée par un fil électrique d'un diamètre relativement grand sur une unité électronique de petites dimensions ayant des plots ou plages de dimensions standard, c'est-à-dire des plots ou plages pouvant présenter de très petites dimensions. On remarquera que le plot peut présenter diverses formes permettant de réaliser un assemblage solide entre l'antenne et le circuit électronique. En particulier, la surface supérieure du plot ne doit plus être nécessairement plane mais peut être bombée ou même avoir une forme sensiblement pointue. Ensuite, on remarquera que les tolérances de fabrication des divers éléments du dispositif de communication et les tolérances de positionnement lors de l'assemblage de ces éléments n'engendrent pas dans le cadre de la présente invention une augmentation des dimensions des plots de connexion, ces tolérances étant aisément couvertes par les zones aplaties qui permettent d'assurer que les plots de connexion soient respectivement situés en regard de ces zones aplaties lors de l'étape de soudage ou généralement lors de la liaison électrique entre l'unité électronique et l'antenne.

### Brève description des dessins

D'autres caractéristiques et avantages du procédé de fabrication selon l'invention ressortiront également de la description suivante de modes de mise en oeuvre du procédé selon l'invention, faite en référence aux dessins annexés, donnés à titre d'exemples nullement limitatifs, dans lesquels :
- la figure 1 représente schématiquement une antenne-bobine avec deux zones d'extrémité aplaties selon l'invention ;
- la figure 2 représente de manière schématique l'antenne de la figure 1 reliée à une unité électronique présentant deux plots externes de connexion ;
- les figures 3, 3A, 3B, 3C et 3D représentent schématiquement diverses étapes d'un premier mode de mise en oeuvre du procédé de fabrication selon l'invention ;
- la figure 4 représente schématiquement une antenne-bobine agencée sur un support avec ses deux extrémités s'étendant au-dessus d'une ouverture traversante, cette bobine et son support formant un produit spécifique intervenant dans un deuxième mode de mise en oeuvre du procédé de fabrication selon l'invention ;
- les figures 5, 5A et 5B représentent schématiquement des étapes du deuxième mode de mise en oeuvre du procédé de fabrication selon l'invention ;
- la figure 6 montre schématiquement en coupe partielle le dispositif de communication RF obtenu par le procédé de l'invention selon ledit second mode de mise en oeuvre ; et
- les figures 7A et 7B représentent schématiquement deux unités électroniques pouvant être utilisées dans le cadre du procédé de l'invention.

### Description détaillée

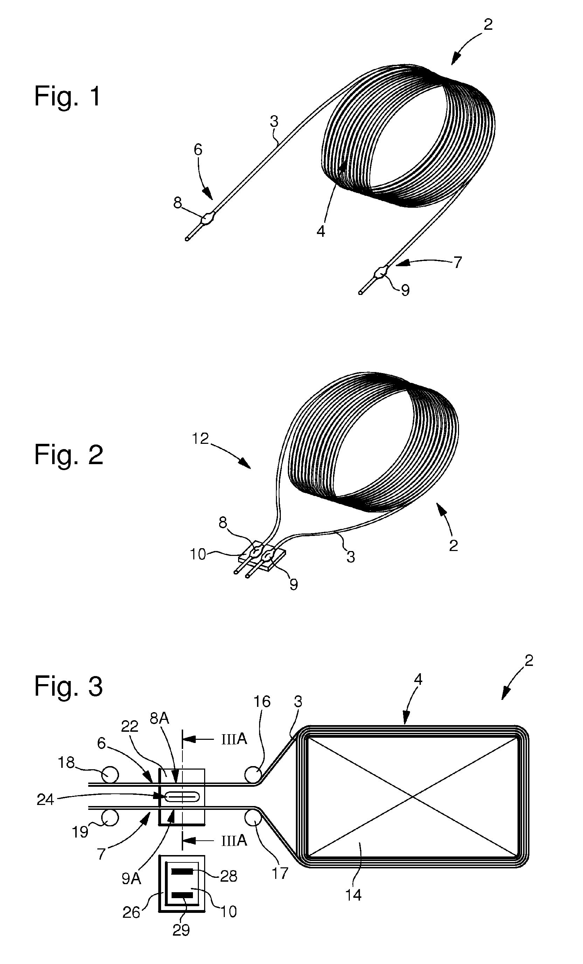

A la figure 1 est représenté schématiquement une variante de réalisation d'une antenne-bobine 2 selon la présente invention. Cette antenne 2 est formée d'un fil électrique 3 qui définit d'une part un enroulement 4 et deux extrémités 6 et 7. Deux zones respectives 8 et 9 de ces deux extrémités sont aplaties avant que l'antenne soit assemblée à une unité électronique 10 pour former un dispositif de communication RF 12 représenté à la figure 2. Les zones aplaties 8 et 9 recouvrent deux plages ou plots de connexion respectifs du circuit électronique auxquels elles sont soudées.

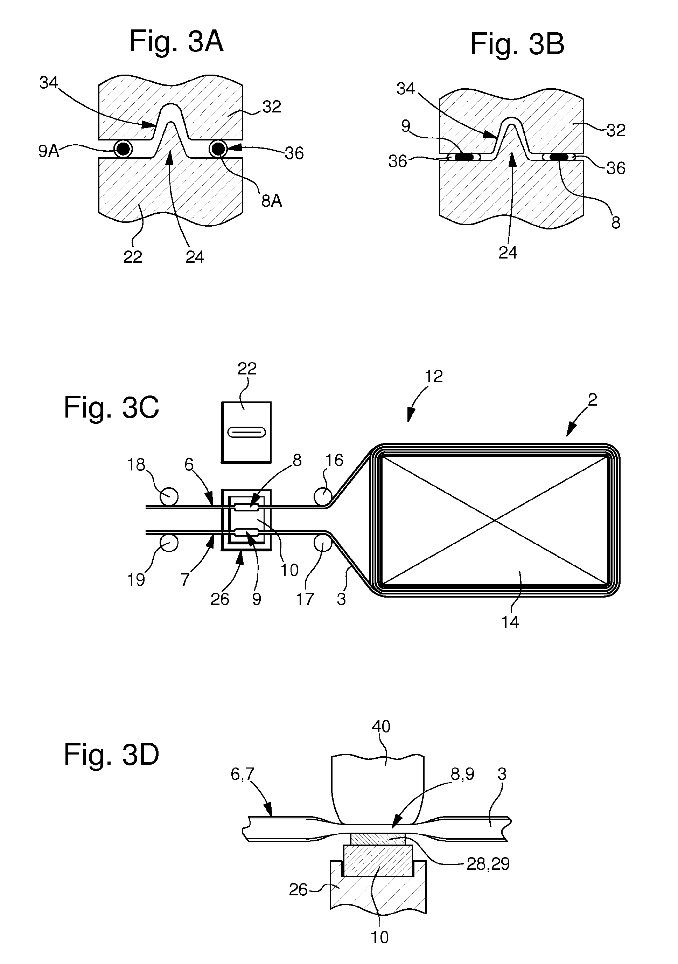

A l'aide des figures 3 à 3D on décrira ci-après un premier mode de mise en oeuvre du procédé de fabrication d'un dispositif de communication selon l'invention. Une antenne-bobine 2 est formée à l'aide d'un fil électrique isolé 3. L'enroulement ou le corps de bobine 4 est effectué autour d'un noyau 14 et les extrémités 6, 7 de l'antenne 2 sont disposées parallèlement au-dessus d'une première partie 22 d'une presse par des moyens de guidage 16, 17, 18 et 19. Deux zones d'extrémité 8A et 9A sont situées au-dessus de la première partie 22 de la presse qui présente entre ces deux zones une partie saillante 24 servant à assurer que les zones 8A et 9A, ne viennent pas en contact lors de leur écrasement à l'aide d'une deuxième partie 32 de la presse, comme représenté aux figures 3A et 3B. La partie saillante 24 forme une sorte de lame évasée dans la variante représentée ici. On notera toutefois que d'autres formes sont envisageables et que cette partie saillante n'est pas indispensable au procédé de l'invention.

Lorsque les zones 8A et 9A sont aplaties par écrasement à froid, la gaine isolante 36 entourant le fil métallique est également écrasée. Etant de moindre résistance que le fil métallique interne, cette gaine isolante 36 peut s'étendre latéralement comme représenté à la figure 3B. Ainsi la gaine isolante 36 peut constituer un tampon ou une zone d'isolation entre les deux zones d'extrémité aplaties 8 et 9 du fil électrique. Cependant, l'étape d'écrasement des zones d'extrémité pour former des zones aplaties 8 et 9 peut être mise en oeuvre de manière à éloigner définitivement la gaine isolante dans la région des zones aplaties. On notera que l'écrasement préliminaire prévu peut être réalisé également avec un certain apport de chaleur de manière à fondre la gaine isolante et à ramollir un peu le fil métallique pour favoriser son écrasement sans tension résiduelle. L'apport de chaleur peut être effectué au travers de la presse ou par des moyens additionnels avant ou après l'écrasement. Diverses variantes sont donc à disposition de l'homme du métier pour enlever localement la gaine isolante. On remarquera que cette gaine isolante peut aussi être enlevée lors du soudage si elle n'a pas été enlevée entièrement précédemment. Lors du développement du procédé selon l'invention, on a observé qu'un écrasement à froid avec une presse ayant une arête vive sur son pourtour permet d'enlever entièrement la gaine isolante dans les zones aplaties.

Dans une variante préférée du premier mode de mise en oeuvre du procédé de l'invention, lors de la formation de l'antenne, les deux extrémités 6 et 7 de cette antenne sont positionnées l'une relativement à l'autre, dans une région prévue pour l'assemblage au circuit électronique 10, avec un écart entre leurs axes centraux respectifs correspondant approximativement à une distance entre des points respectifs des deux plages ou plots 28 et 29 du circuit électronique ou avec un écart légèrement supérieur. En particulier, lors de la formation de l'antenne 2, le fil est guidé de manière que les zones 8A et 9A des extrémités 6 et 7 de l'antenne puissent, une fois aplaties, être superposées aux plages ou plots de connexion 28 et 29 du circuit électronique auxquels l'antenne est ensuite assemblée, comme représenté aux figures 3C et 3D. Avant d'effectuer cet assemblage, les zones d'extrémité 8A et 9A sont donc écrasées dans une presse pour former des zones aplaties 8 et 9 destinées à être reliées électriquement aux plages ou plots 28 et 29 du circuit électronique. Le positionnement des extrémités du fil de l'antenne lors de sa formation et l'écrasement des zones d'extrémité dans cette configuration permet ainsi d'assurer que les plages ou plots 28 et 29 du circuit électronique soient correctement positionnés en face respectivement des deux zones aplaties du fil électrique 3 formant l'antenne 2.

Pour effectuer l'étape préliminaire d'écrasement des zones d'extrémité, on utilise donc une presse ayant deux parties complémentaires 22 et 32 placées respectivement dessous et dessus les deux zones d'extrémités 8A et 9A à aplatir. Dans la variante représentée sur les figures, la partie inférieure 22 présente deux zones planes qui sont séparées par une zone saillante 24. Les deux zones d'extrémité 8A et 9A sont agencées respectivement sur ces deux zones planes et la partie supérieure 32 est alors placée sur ces zones d'extrémité pour effectuer l'étape d'écrasement de ces zones. La partie 32 présente une gorge 34 dans laquelle se loge la partie saillante 24 lors de la fermeture de la presse. La zone saillante maintient un espace minimum entre les deux zones aplaties 8 et 9 lors de l'étape d'écrasement.

Dans une variante, on utilise une presse à surface plane et on vient ensuite avec une lame entre les deux zones aplaties pour les séparer au cas où elles se toucheraient. Dans une autre variante, il est prévu de venir avec un outil de découpe dans la région médiane des deux zones aplaties pour engendrer une fente d'une certaine largeur entre ces deux zones aplaties avant l'assemblage à l'unité électronique. Dans une variante perfectionnée, l'outil de découpe définit le profil de chaque zone aplatie des deux côtés du fil électrique.

Lors de l'étape d'écrasement des zones d'extrémité, le circuit électronique 10 est maintenu à l'écart sur un support 26. Une fois l'écrasement des zones d'extrémité effectué, la presse est retirée de la région des zones d'extrémité aplaties et le circuit électronique 10 est apporté dans cette région de manière que ses plots ou plages de connexion 28 et 29 soient situés en face respectivement des zones aplaties 8 et 9. De préférence, ces zones aplaties recouvrent entièrement les plots ou plages 28 et 29, comme cela est représenté à la figure 3C. Ensuite, les zones aplaties 8 et 9 sont reliées électriquement aux plots ou plages de connexion pour former un dispositif de communication RF selon l'invention. De préférence, cette liaison électrique est effectuée par soudage à l'aide d'une thermode 40, comme représenté à la figure 3D. Une fois le soudage terminé, il est possible de prévoir l'apport d'une goutte de résine de manière à protéger les zones d'extrémité aplaties 8 et 9 et également pour isoler les zones dénudées du fils du corps du circuit intégré. Toutefois, une telle protection n'est pas indispensable dans chaque cas.

On remarquera que lorsque la largeur des zones aplaties 8 et 9 est bien supérieure à la largeur des plots 28 et 29 du circuit 10, ces plots ne doivent pas nécessairement être situés respectivement au milieu des deux zones aplaties lors de l'étape de soudage. En effet, il suffit que les zones aplaties 8 et 9, qui présentent une surface inférieure sensiblement plane, recouvrent ces plots de connexion pour assurer un soudage correct et garantir ainsi une bonne connexion électrique.

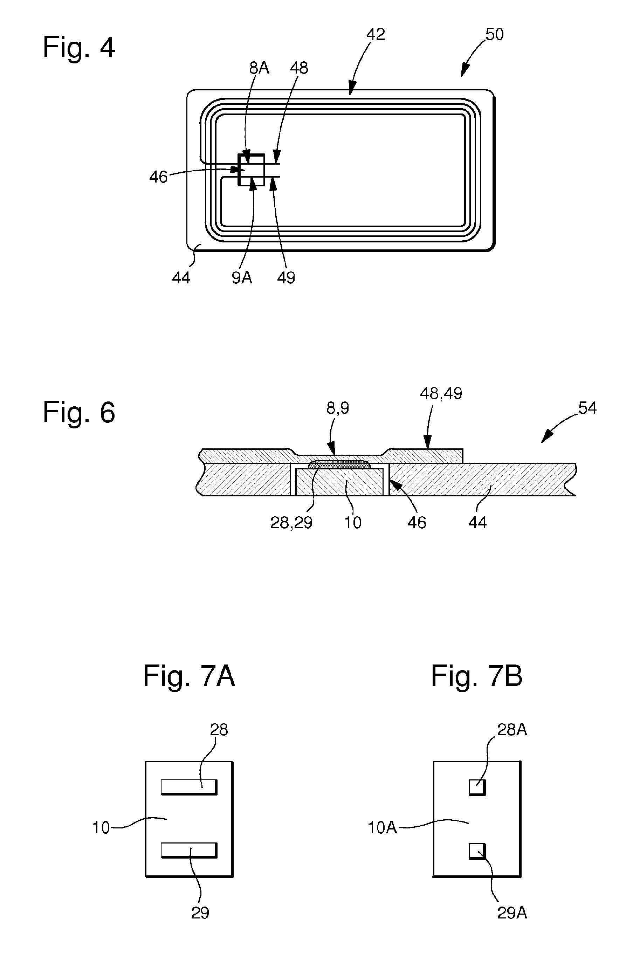

A l'aide des figures 4 à 6 on décrira ci-après un deuxième mode de mise en oeuvre du procédé de fabrication selon l'invention. Comme représenté à la figure 4, l'antenne 42 est formée d'un fil électrique déposé sur un support 44. Ce support 44 est formé par exemple d'une couche plastique ou d'une feuille en cellulose. Le support 44 présente une fenêtre ou ouverture traversante 46. L'antenne 42 est formée par un enroulement agencé sur une seule couche et définissant une bobine plane. Le fil électrique formant l'antenne 42 est fixé au moins par endroits au support 44. En particulier ce fil est poussé au moins partiellement dans la matière formant la couche 44, en particulier lorsque celle-ci est formée d'un matériau plastique, ou est maintenu sur le support 44 notamment par collage. Le fil de la bobine peut présenter une enveloppe extérieure thermocollante. En chauffant le fil électrique lors de la formation de l'antenne 42, celui-ci adhère au support 44 de manière à former des spires régulières comme représenté à la figure 4. Les deux extrémités de l'antenne 42 sont agencées parallèlement l'une à l'autre de manière à traverser entièrement l'ouverture 46 prévue dans le support 44. Chaque extrémité présente une zone 8A, respectivement 9A tendue au-dessus de l'ouverture traversante 46 et une zone terminale 48, respectivement 49. Les zones terminales 48 et 49 étant fixées au support 44, le positionnement des zones d'extrémité 8A et 9A est assuré. On obtient ainsi un premier produit intermédiaire 50 intervenant dans le procédé de l'invention.

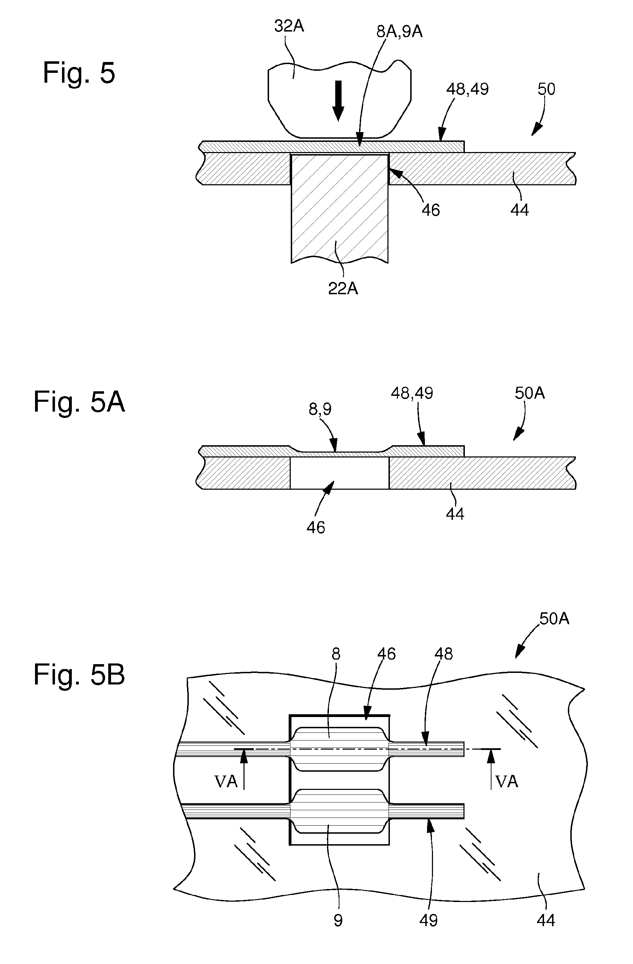

Comme représenté aux figures 5, 5A et 5B, les zones d'extrémités 8A et 9A de l'antenne 42 sont aplaties par écrasement de manière similaire au premier mode de mise en oeuvre décrit précédemment. Une première partie 22A d'une presse est introduite dans l'ouverture 46 avec sa surface supérieure située sensiblement au niveau de la face supérieure du support 44. Toutefois, lorsque le fil d'antenne est enfoncé au moins partiellement dans le support 44, on agence la partie inférieure 22A de la presse de manière à ce que sa surface supérieure soit sensiblement en contact avec les zones d'extrémités 8A et 9A, c'est-à-dire légèrement en retrait par rapport à la face supérieure du support 44. Ensuite, à l'aide de la partie supérieure 32A de la presse, les deux zones 8A et 9A situées au-dessus de l'ouverture 46 sont aplaties par écrasement pour obtenir un deuxième produit intermédiaire 50A représenté aux figures 5A et 5B. Après l'étape préliminaire d'écrasement des zones d'extrémité de l'antenne, celle-ci présente deux zones aplaties 8 et 9 superposées à l'ouverture 46 dans laquelle il est prévu de loger un circuit électronique 10.

Le circuit électronique 10 peut être formé d'un simple circuit intégré présentant deux plages ou de préférence deux plots de connexion sur sa surface supérieure. Dans une variante, le circuit intégré peut être enrobé dans une masse d'enrobage et présenter deux plages ou plots de connexion externe. Cependant, le procédé de fabrication selon l'invention est particulièrement bien adapté pour assurer une connexion directe entre un circuit intégré et l'antenne 42. Comme représenté à la figure 7A, le circuit électronique 10 peut présenter deux plots allongés 28 et 29. Toutefois, le circuit électronique peut être formé par un circuit intégré classique 10A, représenté schématiquement à la figure 7B. Ce circuit intégré comprend deux petits plots standard 28A et 29A.

Comme représenté à la figure 6, un circuit électronique 10 est inséré dans l'ouverture 46 avec ses plots de connexion 28 et 29 situés en face des deux zones aplaties 8 et 9 qui s'étendent au-dessus de cette ouverture. Les plots de connexion du circuit 10 sont ensuite soudés aux zones aplaties par une technique quelconque connue de l'homme du métier, notamment par un soudage électrique, par un soudage laser ou par thermo-compression. On notera que dans le cas d'une thermo-compression, la déformation initiale des zones d'extrémité en zones aplaties de moindre épaisseur que le diamètre du fil et de largeur supérieure à ce diamètre permet d'effectuer un soudage avec une moindre pression pour relier électriquement le circuit électronique à l'antenne. De plus, la quantité d'énergie à fournir peut être moindre que dans le cas d'une thermo-compression effectuée directement sur les extrémités du fil d'antenne, comme proposé dans l'art antérieur. Le fait que les zones aplaties présentent une surface inférieure sensiblement plane permet également d'assurer un maintien en position de ces zones d'extrémité lors de l'étape de soudage et de garantir ainsi une bonne connexion électrique entre le circuit électronique et l'antenne. De plus, le fait que les zones aplaties du fil d'antenne soient situées au-dessus ou au-dessous de l'ouverture traversante et que les plots du circuit intégré sont agencés en face de ces zones aplaties permet de réaliser une thermo-compression à l'intérieur du pourtour de cette ouverture traversante. Contrairement à la présente invention, si le circuit électronique ou les pattes de connexion d'un module électronique sont disposés sur le support qui est généralement assez mou, il n'est pas possible d'effectuer une thermo-compression pour souder le fils d'antenne à ce circuit ou module.

Ainsi, grâce aux caractéristiques du procédé de fabrication selon l'invention, il est possible d'effectuer un soudage efficace pour relier électriquement le circuit électronique à l'antenne en limitant la pression et la chaleur apportée, ce qui rend cette étape de soudage moins critique pour le circuit électronique. Comme les zones aplaties 8 et 9 présentent une largeur relativement grande, le circuit électronique peut être positionné dans l'ouverture 46 avec une tolérance relativement grande. Le procédé de fabrication selon l'invention permet donc d'obtenir avec un haut rendement industriel des dispositifs de communication RF 54 tels que représentés partiellement en coupe à la figure 6.

## Revendications

1. Procédé de fabrication d'un dispositif de communication RF comprenant une antenne formée par un fil électrique et au moins une unité électronique comprenant des plots ou plages de connexion à ladite antenne qui sont reliés électriquement à des zones respectives de cette antenne, **caractérisé en ce que** ces zones respectives sont aplaties par écrasement dans une étape préliminaire à l'assemblage de l'antenne avec ladite unité électronique, cet assemblage étant réalisé en positionnant lesdits plots ou plages de connexion en face respectivement des zones aplaties dudit fil électrique.

2. Procédé de fabrication selon la revendication 1, **caractérisé en ce que**, lors de la formation de ladite antenne, deux extrémités de cette dernière sont positionnées l'une relativement à l'autre, dans une région prévue pour ledit assemblage à ladite unité électronique, avec un écart entre leurs axes centraux respectifs correspondant approximativement à une distance entre des points respectifs de deux plots ou plages de connexion de cette unité électronique, l'écrasement de deux zones d'extrémité de ce fil électrique étant ensuite effectué par une presse dans ladite région.

3. Procédé de fabrication selon la revendication 2, **caractérisé en ce que** ladite presse comprend deux parties complémentaires, placées respectivement dessous et dessus les deux zones d'extrémité à aplatir, une des deux parties ayant une surface de pressage présentant deux zones planes séparées par une zone saillante, lesdites deux zones d'extrémité étant agencées respectivement sur les deux zones planes avant leur écrasement, ladite zone saillante maintenant un espace minimum entre les deux zones aplaties après l'étape d'écrasement.

4. Procédé de fabrication selon la revendication 2 ou 3, **caractérisé en ce que**, après l'écrasement des deux zones d'extrémités, ladite presse est retirée et ladite unité électronique est apportée à proximité des deux zones aplaties dudit fil électrique avec deux plots ou plages de connexion positionnés respectivement en face de ces deux zones aplaties, lesquelles sont ensuite soudées aux deux plots ou plages par un dispositif de soudage.

5. Procédé de fabrication selon l'une des revendications 1 à 4, **caractérisé en ce que** ledit fil électrique de l'antenne est déposé sur un support avant ladite étape d'écrasement desdites zones de ce fil électrique, ce support présentant une ouverture traversante prévue pour y loger ladite unité électronique, lesdites zones à aplatir du fil électrique étant agencées au-dessus ou au-dessous de ladite ouverture traversante, ladite étape d'écrasement de ces zones étant effectuée ensuite avec ladite presse avant l'apport de ladite unité électronique.

6. Procédé selon la revendication 5, **caractérisé en ce que**, suite à ladite étape d'écrasement, ladite unité électronique est introduite dans ladite ouverture traversante et ensuite les plots ou plages de ladite unité électronique sont reliés électriquement aux zones aplaties de l'antenne.

7. Procédé selon la revendication 6, **caractérisé en ce que** l'assemblage entre l'antenne et ladite unité électronique est réalisé par thermo-compression.

8. Procédé selon l'une des revendications précédentes, **caractérisé en ce que** ladite unité électronique est un circuit intégré présentant à une surface lesdits plots ou plages de connexion électrique.

9. Procédé selon la revendication 8, **caractérisé en ce qu'**il est prévu d'apporter au moins une goutte de matière isolante autour des zones aplaties après que celles-ci aient été reliées à ladite unité électronique par soudage.

10. Procédé selon l'une des revendications précédentes, **caractérisé en ce qu'**après l'écrasement desdites zones, un outil de découpe est appliqué sur les zones aplaties pour définir au moins partiellement le profil de ces zones aplaties.
